(19) Europäisches Patentamt / European Patent Office / Office européen des brevets

(11) **EP 2 762 446 B1**

(12) **EUROPEAN PATENT SPECIFICATION**

(45) Date of publication and mention
of the grant of the patent:
**07.06.2017 Bulletin 2017/23**

(51) Int Cl.:
*C22C 9/00* (2006.01)     *C22C 9/02* (2006.01)
*B21B 1/40* (2006.01)     *B21B 3/00* (2006.01)
*C22F 1/08* (2006.01)     *C23C 16/26* (2006.01)
*C25F 3/22* (2006.01)     *B82Y 30/00* (2011.01)

(21) Application number: **12845162.2**

(22) Date of filing: **26.10.2012**

(86) International application number:
**PCT/JP2012/077745**

(87) International publication number:
**WO 2013/065601 (10.05.2013 Gazette 2013/19)**

(54) **COPPER FOIL FOR GRAPHENE PRODUCTION AND PRODUCTION METHOD THEREFOR, AND GRAPHENE PRODUCTION METHOD**

KUPFERFOLIE ZUR GRAPHENHERSTELLUNG UND HERSTELLUNGSVERFAHREN DAFÜR SOWIE HERSTELLUNGSVERFAHREN FÜR GRAPHEN

FEUILLE DE CUIVRE POUR LA PRODUCTION DE GRAPHÈNE ET PROCÉDÉ DE PRODUCTION DE CELLE-CI, ET PROCÉDÉ DE PRODUCTION DE GRAPHÈNE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.11.2011 JP 2011241953**

(43) Date of publication of application:
**06.08.2014 Bulletin 2014/32**

(73) Proprietor: **JX Nippon Mining & Metals Corporation**
**Tokyo 100-8164 (JP)**

(72) Inventor: **CHIBA Yoshihiro**
**Hitachi-shi**
**Ibaraki 317-0056 (JP)**

(74) Representative: **Prüfer & Partner mbB**
**Patentanwälte · Rechtsanwälte**
**Sohnckestraße 12**
**81479 München (DE)**

(56) References cited:
**EP-A1- 2 664 580      EP-A1- 2 873 744**
**JP-A- 2004 074 214    JP-A- 2010 227 971**

• **ZHENGTANG LUO ET AL.: 'Effect of Substrate Roughness and Feedstock Concentration on Growth of Wafer-Scale Graphene at Atmospheric Pressure' CHEMISTRY OF MATERIALS vol. 23, no. 6, 22 March 2011, pages 1441 - 1447, XP002695338**

**Description**

[Field of the Invention]

The present invention relates to a copper foil for producing graphene, a production method thereof and a method of producing graphene.

[Description of the Related Art]

Graphite has a layered structure where a plurality of layers of carbon six-membered rings planarly arranged is laminated. The graphite having a mono atomic layer or around several atomic layers is called as graphene or a graphene sheet. The graphene sheet has own electrical, optical and mechanical properties, and in particularly has a high carrier mobility speed. Therefore, the graphene sheet has expected to be applied in various industries as a fuel cell separator, a transparent electrode, a conductive thin film for a display device, a "mercury-free" fluorescent lamp, a composite material, a carrier for Drug Delivery System (DDS) etc.

As a method of producing the graphene sheet, it is known that graphite is peeled with an adhesion tape. However, there are problems in that the number of the layer(s) of the graphene sheet obtained is not uniform, a wide area graphene sheet is difficult to be provided, and it is not suitable for mass production.

A technology has been developed that a sheet-like monocrystal graphitized metal catalyst is contacted with a carboneous substance and then is heat treated to grow the graphene sheet (Chemical Vapor Deposition (CVD) method) (Patent Literature 1). As the monocrystal graphitized metal catalyst, there is described a metal substrate made of Ni, Cu or W, for example.

Similarly, a technology has been reported that a graphene film is formed by the chemical vapor deposition method on a copper layer formed on an Ni or Cu metal foil or an Si substrate. The graphene film is formed at about 1000°C (Non-Patent Literature 1).

In addition, a technology has been reported that a graphene film is formed on an electropolished copper foil (Non-Patent Literature 2).

[Prior Art Literature]

[Patent Literature]

[Patent Literature 1] Japanese Unexamined Patent Publication (Kokai) 2009-143799

[Non-Patent Literature]

[Non-Patent Literature 1] SCIENCE Vol. 324 (2009) P1312-1314

[Summary of Invention]

[Problems to be solved by the Invention]

However, it is not easy and spends high costs to produce the monocrystal metal substrate, a wide area substrate is difficult to be provided, and a wide area graphene sheet is thus difficult to be provided, as described in Patent Document 1. On the other hand, Non-Patent Document 1 describes that Cu is used as the substrate. Graphene is not grown on a copper foil in a plane direction within a short time. A Cu layer formed on an Si substrate is annealed to provide coarse grains, thereby providing a substrate. In this case, a size of graphene is limited to the size of the Si substrate, and its production costs are high, too.

It is found that when the copper foil was used as the substrate to produce graphene, a production yield of the graphene could not be increased if a copper foil surface was not extremely smooth. This is because the smoother the copper foil surface is, the fewer unevenness that inhibits the growth of graphene, thereby forming a graphene film evenly on the copper foil surface. In this way, the copper foil having a smooth surface can be produced by using high purity copper (having a purity of over 99.999%). However, the copper foil is produced at high costs and has a limited size. Alternatively, when the copper foil surface is smoothed by rolling etc., it is necessary to strictly define production conditions including a rolling reduction ratio, which also leads to high costs.

According to the technology described in Non-Patent Literature 2, a copper foil is electropolished using an electrolytic solution containing phosphoric acid at 1.0 to 2.0V for 0.5 hours (see p.1442). In non-Patent Literature 2, there is no description about an area of a copper foil sample used, but the copper foil sample is placed within a quartz tube having a size of 1 inch (equals to about 2.5 cm) to form a graphene film by CVD (see p.1442). The present inventors double-checked the test assuming that the area of the copper foil sample was 1 cm$^2$. As a result, there was a small amount of the electropolishing, and the production yield of the graphene was not high.

Accordingly, an object of the present invention is to provide a copper foil for producing graphene being capable of producing graphene having a large area with low costs, a production method thereof and a method of producing graphene.

[Means for Solving the Problems]

The present invention provides a copper foil for producing graphene having a ratio ($Ra_1/Ra_2$) between an arithmetic mean roughness $Ra_1$ in a rolling direction and an arithmetic mean roughness $Ra_2$ in a direction transverse to rolling direction of $0.7 <= (Ra_1/Ra_2) <= 1.3$.

Preferably, the ratio ($Ra_1/Ra_2$) is $0.8 <= (Ra_1/Ra_2) <= 1.2$ after heating at 1000 °C for 1 hour in an atmosphere containing 20% by volume or more of hydrogen and balance argon.

Preferably, in the copper foil for producing graphene of the present invention consists of tough pitch copper in accordance with JIS-H3100, or consists of oxygen free copper in accordance with JIS-H3100, or contains from 0.001% by mass to 0.15% by mass of one or more of elements selected from the group consisting of Sn and Ag to the tough pitch copper or the oxygen free copper.

Preferably, 60 degree gloss in the rolling direction and 60 degree gloss in the direction transverse to rolling direction are each 200% or more.

The present invention provides a method of producing the copper foil for producing graphene, electropolishing a surface of a copper foil substrate to 0.5 μm or more in a depth direction.

Further, the present invention provides a method of producing the copper foil for producing graphene according to any one of Claims 1 to 4, rolling with a roll having a ratio ($Ra_{1roll}/Ra_{2roll}$) between an arithmetic mean roughness in a circumferential direction $Ra_{1roll}$ and an arithmetic mean roughness in a width direction $Ra_{2roll}$ is $0.8 <= (Ra_{1roll}/Ra_{2roll}) <= 1.2$ at a final pass of a final cold rolling.

The present invention provides a method of producing grapheme using the copper foil for producing graphene according to any one of Claims 1 to 4, comprising the steps of: providing a hydrogen and carbon-containing gas while placing the heated copper foil in a chamber to form graphene on a surface of the copper plating layer of the copper foil for producing graphene; laminating a transfer sheet on the surface of the graphene, and etching and removing the copper foil for producing graphene while transferring the graphene to the transfer sheet.

[Effect of the Invention]

According to the present invention, there can be provided a copper foil being capable of producing graphene having a large area with low costs.

[Brief Description of Drawing]

[Fig. 1] A process chart showing a method of producing graphene according to an embodiment of the present invention.
[Fig. 2] Confocal micrographs of the surface of the sample in Example 6 after the sample was finally cold rolled, electropolished, and then heated at 1000°C for 1 hour respectively.

[Description of the Embodiments]

Hereinafter, a copper foil for producing graphene and a method of producing graphene according to an embodiment of the present invention will be described. The symbol "%" herein refers to % by mass, unless otherwise specified.

<Composition of Copper foil>

As the copper foil, tough pitch copper (TPC) in accordance with JIS-H3100, or oxygen free copper (OFC) in accordance with JIS-H3510 or JIS-H3100 can be used.

In addition, to the tough pitch copper or the oxygen free copper, a composition containing 0.15 % by mass or less in total of one or more of elements selected from the group consisting of Sn and Ag can be used. When the above-described elements are contained, the copper foil can have improved strength and adequate elongation, and the grain size can be increased. If a content percentage of the above-described elements exceeds 0.15 % by mass, the strength may be further increased, but the elongation may be decreased to degrade workability and suppress the growth of the grain size. More preferably, a total content percentage of the above-described elements is 0.10% by mass or less, still more preferably 0.050% by mass or less, most preferably 0.040% by mass.

Although a lower limit of the total content percentage of the above-described elements is not especially limited, for example the lower limit may be 0.001 % by mass. If the content percentage of the above-described elements is less than 0.001 % by mass, the content percentage may be difficult to be controlled. Preferably, a lower limit of the content percentage of the above-described elements is 0.003% by mass or more, more preferably 0.004% by mass or more, most preferably 0.005% by mass or more.

<Thickness>

The thickness of the copper foil is not especially limited, but is generally 5 to 150 $\mu$m. Preferably, the thickness of the copper foil substrate is 12 to 50 $\mu$m for ease of etching and removal as described later while assuring handleability. If the thickness of the copper foil substrate is less than 12 $\mu$m, it may be easily broken and have less handleability. If the thickness exceeds 50 $\mu$m, etching and removal may be difficult.

<Arithmetic Mean Roughness Ra of Copper Foil Surface>

A ratio ($Ra_1/Ra_2$) between an arithmetic mean roughness $Ra_1$ of the copper foil surface in a rolling direction and an arithmetic mean roughness $Ra_2$ of the copper foil surface in a direction transverse to rolling direction is $0.7 <= (Ra_1/Ra_2) <= 1.3$.

The present inventors studied about a copper foil having a smooth surface provided by using no high purity copper (having a purity of over 99.999%), and found that when the surface of the copper foil substrate was electropolished to a depth of 0.5 $\mu$m or more, the ($Ra_1/Ra_2$) was within 0.7 to 1.3, anisotropy of Ra of the copper foil is decreased, and the surface became smooth such that the growth of graphene was not inhibited. Thus, when the ($Ra_1/Ra_2$) exceeds 1.3 or is less than 0.7, the anisotropy of Ra of the copper foil is increased and graphene having a large area does not grow. Preferably, the ($Ra_1/Ra_2$) is $1.1 <= (Ra_1/Ra_2) <= 1.3$. The electropolishing can be carried out at 8 to 15 $V/cm^2$ for 10 to 30 seconds, for example.

In addition, the present inventors found that the copper substrate is rolled by decreasing a difference between roughness in a circumferential direction and roughness in a width direction on the surface of the roll used in a final pass of a final cold rolling when the surface of the copper substrate is not electropolished, thereby providing an effect equivalent to the case that the electropolishing is carried out to a depth of 0.5 $\mu$m or more. This is because the surface of the roll is transferred to the surface of the copper foil substrate. To decrease the difference between the roughness in the circumferential direction and the roughness in the width direction on the surface of the roll, the surface of the roll is ground by a grinding wheel and buffed. For example, there can be used the roll having a ratio ($Ra_{1roll}/Ra_{2roll}$) between an arithmetic mean roughness in a circumferential direction $Ra_{1roll}$ and an arithmetic mean roughness in a width direction $Ra_{2roll}$ is $0.8 <= (Ra_{1roll}/Ra_{2roll}) <= 1.2$.

Furthermore, after heating at 1000°C for 1 hour in an atmosphere containing 20% by volume or more of hydrogen and balance argon, the ratio ($Ra_1/Ra_2$) is preferably $0.8 <= (Ra_1/Ra_2) <= 1.2$. The above-described heating condition is simulated for a condition of heating the copper foil for producing graphene at not less than a decomposition temperature of the carbon-containing gas when graphene is produced.

The $Ra_1$ and $Ra_2$ of the copper foil surface are determined by measuring an arithmetic mean roughness (Ra; $\mu$m) in accordance with JIS-B0601 using a non-contact laser surface roughness meter (a confocal microscope manufactured by Lasertec Corporation, HD100D). The roughness may be measured 10 times in each direction, i.e., a rolling direction and a direction transverse to rolling direction under the condition that a measurement sampling length is 0.8 mm, an evaluation length is 4 mm, a cut off value is 0.8 mm and a feed speed is 0.1 mm/sec.

<60 Degree Gloss>

60 degree gloss (JIS Z8741) of the copper foil for producing graphene is 200% or more both in a rolling direction and a direction transverse to rolling direction.

As described later, after graphene is produced using the copper foil for producing graphene according to the present invention, the graphene is needed to be transferred from the copper foil to a transfer sheet. It is found that when a surface of the copper foil is rough, it is difficult to transfer the graphene, and the graphene is broken. Therefore, it is necessary that the surface irregularity of the copper foil be smooth.

An upper limit of the 60 degree gloss in each of the rolling direction and the direction transverse to the rolling direction is not especially limited. If the upper limit is set to less than 500%, production conditions for rolling reduction ratio or so may not be strictly specified upon the production of the copper foil, whereby advantageously increasing a degree of production freedom. Practically, the upper limit of the 60 degree gloss each of in the rolling direction and the direction transverse to the rolling direction is about 800%.

In addition, in order to ease the transfer of the graphene to the transfer sheet, the arithmetic mean roughness $Ra_1$ of preferably 0.13 $\mu$m or less.

Using the copper foil for producing graphene as specified above, the large-area graphene can be produced at low costs and a high yield.

<Production of Copper Foil for producing Graphene>

The copper foil for producing graphene according to the embodiment of the present invention can be produced as follows, for example: Firstly, a copper ingot having a predetermined composition is produced, is hot rolled, and is annealed and cold rolled repeatedly to provide a rolled sheet. The rolled sheet is annealed to be re-crystallized, and finally cold rolled to the predetermined thickness of a rolling reduction of 80 to 99.9% (preferably 85 to 99.9%, more preferably 90 to 99.9%), thereby providing a copper foil substrate.

Next, the surface of the copper foil substrate is electropolished to a depth of 0.5 $\mu$m or more. By electropolishing, a sulfide on the surface of the copper foil substrate is removed. When the copper foil for producing graphene is heated at a temperature at which a carbon containing gas is decomposed or more, a smooth surface is achieved with less bulges and dents caused by the sulfide.

The electropolishing is preferably carried out using a variety of acid solutions (for example, a sulfuric acid solution, and a phosphoric acid 65% + sulfuric acid 10% + water 25% solution) at a voltage of about 10 V/cm$^2$.

Alternatively, the copper foil for producing graphene according to an embodiment of the present invention may be produced using a roll having a ratio ($Ra_{1roll}/Ra_{2roll}$) between an arithmetic mean roughness in a circumferential direction $Ra_{1roll}$ and an arithmetic mean roughness in a width direction $Ra_{2roll}$ is 0.8 <= ($Ra_{1roll}/Ra_{2roll}$) <= 1.2 at a final pass of a final cold rolling. In this way, the copper foil can be produced by decreasing the ratio (close to 1.0) between the arithmetic mean roughness $Ra_1$ of the copper foil surface in the rolling direction and the arithmetic mean roughness $Ra_2$ of the copper foil surface in the direction transverse to rolling direction.

A value of the $Ra_{1roll}/Ra_{2roll}$ of the roll can be adjusted by buffing after the roll is subjected to typical cylindrical grinding. Also, the value can be adjusted by hard chrome plating (a plated thickness of 5 $\mu$m or more) and then by buffing after the roll is subjected to typical cylindrical grinding.

<Method of producing Graphene>

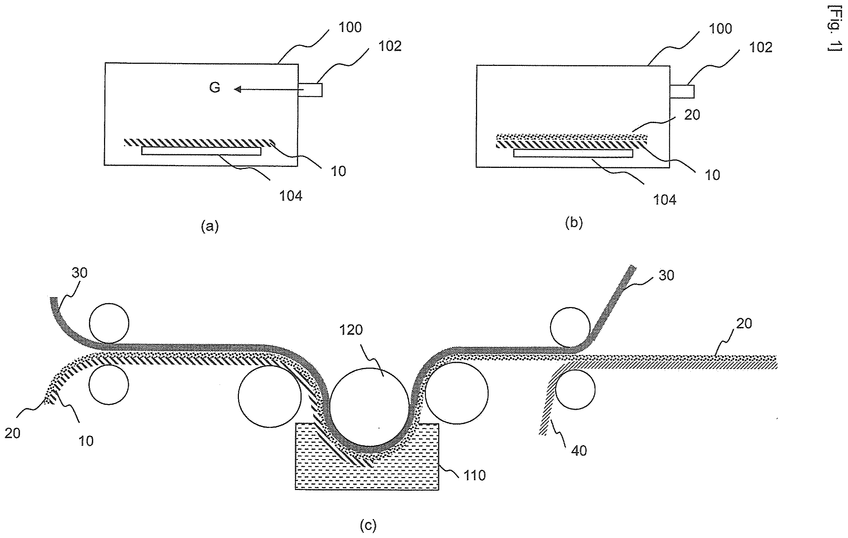

Next, referring to Fig. 1, a method of producing graphene according to the embodiment of the present invention will be described.

First, the above-described copper foil 10 for producing graphene of the present invention is placed in a chamber (such as a vacuum chamber) 100 and is heated by a heater 104. At the same time, the pressure in the chamber 100 is reduced or the chamber 100 is vacuum-evacuated. Then, a carbon-containing gas G is fed to the chamber 100 together with a hydrogen gas through a gas supply inlet 102 (Fig. 1(a)). As the carbon-containing gas G, carbon dioxide, carbon monoxide, methane, ethane, propane, ethylene, acetylene, alcohol or the like is cited, but is not limited thereto. One or more of these gases may be mixed. The copper foil 10 for producing graphene may be heated at a decomposition temperature of the carbon-containing gas G or more. For example, the temperature can be 1000°C or more. Alternatively, the carbon-containing gas G may be heated at the decomposition temperature or more within the chamber 100, and the decomposed gas may bring into contact with the copper foil 10 for producing graphene.

At this time, when the copper foil 10 for producing graphene is heated, the copper plated layer becomes a semi-molten state and flows to a concave part on the surface of the copper foil substrate, thereby decreasing the irregularities at an uppermost surface of the copper foil 10 for producing graphene. Then, the smooth surface of the copper foil 10 for producing graphene is contacted with a decomposition gas (a carbon gas) to form the graphene 20 on the surface of the copper foil 10 for producing graphene (see Fig. 1(b)).

Then, the copper foil 10 for producing graphene is cooled to normal temperature, a transfer sheet 30 is laminated on the surface of the graphene 20, and the graphene 20 is transferred to the transfer sheet 30. Next, the laminate is continuously immersed into an etching tank 110 via a sink roll 120, and the copper foil 10 for producing graphene is removed by etching (Fig. 1 (c)). In this way, the graphene 20 laminated on the predetermined transfer sheet 30 can be produced.

In addition, the laminate from which the copper foil 10 for producing graphene is removed is pulled up, and a substrate 40 is laminated on the graphene 20. While the graphene 20 is transferred to the substrate 40, the transfer sheet 30 is removed, whereby the graphene 20 laminated on the substrate 40 can be produced.

As the transfer sheet 30, a variety of resin sheets (a polymer sheet such as polyethylene, polyurethane etc.) can be used. As an etching reagent for etching and removing the copper foil 10 for producing graphene, a sulfuric acid solution, a sodium persulfate solution, a hydrogen peroxide and sodium persulfate solution, or a solution where sulfuric acid is added to hydrogen peroxide can be, for example, used. As the substrate 40, an Si, SiC, Ni or Ni alloy can be, for example, used.

[Example]

<Preparation of Sample>

Each copper ingot having a composition shown in Table 1 was prepared, was hot rolled at 800 to 900°C, and was annealed in a continuous annealing line at 300 to 700°C and cold rolled, which was repeated, to provide a rolled plate. The rolled plate was annealed and re-crystallized in the continuous annealing line at 600 to 800°C, and was finally cold rolled to a thickness of 7 to 50 $\mu$m to provide each copper foil substrate having a thickness shown in Table 1.

In Example 10, a roll having a ratio ($Ra_{1roll}$/$Ra_{2roll}$) between an arithmetic mean roughness in a circumferential direction $Ra_{1roll}$ and an arithmetic mean roughness in a width direction $Ra_{2roll}$ of 1.05 at a final pass of a final cold rolling was used. The value of the ($Ra_{1roll}$/$Ra_{2roll}$) of the roll was adjusted by subjecting to typical cylindrical grinding and thereafter buffing.

Here, the oil film equivalents were adjusted to the values shown in Table 1 at a final pass of the final cold rolling.

The oil film equivalent is represented by the following equation:

$$\text{(Oil film equivalent)} = \{(\text{rolling oil viscosity, kinetic viscosity at } 40°C, \text{cSt}) \times (\text{rolling speed; m/min})\}/\{(\text{yield stress of material; kg/mm}^2) \times (\text{roll angle of bite; rad})\}$$

One surface of each copper foil substrate was electropolished using a phosphoric acid 65% + sulfuric acid 10% + water 25% solution at a voltage of about 10 V/cm$^2$ to produce each copper foil. Each amount (depth) of electroplishing is shown in Table 1. The amount (depth) of electroplishing was calculated from a sample weight before and after the electropolishing by masking an area (10 x 10 mm) to be electropolished.

In Example 10, no electropolishing was carried out.

<Measurement of 60 degree gloss G60>

60 degree gloss was measured for each copper foil (substrate) in each Example and Comparative Example after the final cold rolling, the electropolishing, and the heating at 1000°C for 1 hour in the atmosphere containing 20% by volume or more of hydrogen and balance argon after the electropolishing. The heating at 1000°C for 1 hour in an atmosphere containing 20% by volume or more of hydrogen and balance argon is simulated for a condition of producing graphene.

The 60 degree gross was measured using a gloss meter in accordance with JIS-Z8741 (trade name "PG-1 M" manufactured by Nippon Denshoku Industries Co., Ltd.)

<Measurement of Surface Roughness (Ra, Rz, Sm)>

The surface roughness was measured for each copper foil (substrate) in each Example and Comparative Example after the final cold rolling, the electropolishing, and the heating at 1000°C for 1 hour in the atmosphere containing 20% by volume or more of hydrogen and balance argon after the electropolishing.

A non-contact laser surface roughness meter (a confocal microscope manufactured by Lasertec Corporation, HD100D) was used to measure an arithmetic mean roughness (Ra; $\mu$m) in accordance with JIS-B0601. As to an oil pit depth Rz, a ten point height of roughness profile was measured in accordance with JIS B0601-1994. Under the conditions of a measurement sampling length of 0.8 mm, an evaluation length of 4 mm, a cut off value of 0.8 mm and a feed rate of 0.1 mm/sec, ten measurements were done in parallel with a rolling direction at different measurement positions, and values for ten measurements were determined in each direction. As to a mean distance of the irregularities (Sm; mm), under the conditions of a measurement sampling length of 0.8 mm, an evaluation length of 4 mm, a cut off value of 0.8 mm and a feed rate of 0.1 mm/sec, ten measurements were done in parallel with a rolling direction at different measurement positions, and values for ten measurements were determined in each direction. The Sm is defined as "Mean width of the profile elements" by JIS B0601-2001 (in accordance with ISO4287-1997) that represents a surface texture by a profile curve method, and refers to an average of profile lengths of respective irregularities in a sampling length.

In Tables, "RD" represents each surface roughness in a rolling direction and "TD" represents each surface roughness in a rolling direction and a direction transverse to t rolling direction.

<Production of Graphene>

The copper foil for producing graphene (horizontal and vertical 100 x 100 mm) in each Example was placed in a vacuum chamber, and heated at 1000°C. Under vacuum (pressure: 0.2 Torr), hydrogen gas and methane gas were fed into the vacuum chamber (fed gas flow rate: 10 to 100 cc/min), the copper foil was heated to 1000°C for 30 minutes and held for 1 hour to grow graphene on the surface of the copper foil.

In each Example, graphene was tried to be produced ten times under the above-described conditions, and the surface of the copper foil was observed by the atomic force microscope (AFM) for graphene. When scale-like irregularities were observed on the whole surface by the AFM, graphene might be produced. Based on the number of times of the graphene production when graphene was tried to be produced ten times, a yield was evaluated by the following rating: The rating "Excellent", "Good", or "Not bad" may not have practical problems.

Excellent: Graphene was produced five times or more, when graphene was tried to be produced ten times
Good: Graphene was produced four times, when graphene was tried to be produced ten times
Not bad: Graphene was produced three times, when graphene was tried to be produced ten times
Bad: Graphene was produced two times or less, when graphene was tried to be produced ten times

Table 1 and 2 show the obtained result. In Table 1 and 2, $G60_{RD}$ and $G60_{TD}$ represent 60 degree gloss in a rolling direction and a direction transverse to rolling direction, respectively.

Also in Table 1, "TPC" represents tough pitch copper in accordance with JIS-H3100. "OFC" in Example 13 represents oxygen free copper in accordance with JIS-H3100. OFC in Examples 14 to 17 represents oxygen free copper in accordance with JIS-H3510.

In view of this, "OFC + Sn 1200 ppm" represents that 1200 wt ppm of Sn was added to oxygen free copper in accordance with JIS-H3100.

[Table 1]

| | Composition (wtppm) | Oil film equivalent at final pass of final cold rolling | Thickness ($\mu$m) | Properties after final rolling | | | | | | | | | | Amount of electropolishing (one side)($\mu$m) |
|---|---|---|---|---|---|---|---|---|---|---|---|---|---|---|
| | | | | 60 degree gloss | | Surface roughness($\mu$m) RD | | | Surface roughness($\mu$m) TD | | | $Ra_1$ /$Ra_2$ | | |
| | | | | $G60_{RD}$ | $G60_{TD}$ | $Ra_1$ | $R_t$ | $R_{sm}$ | $Ra_2$ | $R_t$ | $R_{sm}$ | | |
| Ex.1 | TPC | 21,000 | 18 | 138 | 123 | 0.141 | 1.355 | 13.246 | 0.109 | 0.955 | 18.864 | 1.294 | 1.0 |
| Ex.2 | TPC | 21,000 | 35 | 135 | 126 | 0.162 | 1.204 | 14.311 | 0.125 | 0.970 | 19.796 | 1.296 | 1.9 |
| Ex.3 | TPC | 21,000 | 35 | 135 | 126 | 0.162 | 1.204 | 14.311 | 0.125 | 0.970 | 19.796 | 1.296 | 5.0 |
| Ex.4 | TPC | 21,000 | 35 | 135 | 126 | 0.162 | 1.204 | 14.311 | 0.125 | 0.970 | 19.796 | 1.296 | 7.8 |
| Ex.5 | TPC | 21,000 | 50 | 130 | 122 | 0.141 | 1.343 | 14.543 | 0.112 | 0.998 | 19.456 | 1.259 | 0.6 |
| Ex.6 | TPC+Ag190ppm | 21,000 | 18 | 123 | 128 | 0.134 | 1.102 | 11.367 | 0.105 | 0.923 | 15.512 | 1.276 | 0.9 |
| Ex.7 | TPC+Ag190ppm | 21,000 | 35 | 120 | 134 | 0.135 | 0.902 | 11.963 | 0.104 | 0.834 | 15.460 | 1.298 | 2.1 |
| Ex.8 | TPC+Ag190ppm | 21,000 | 35 | 120 | 134 | 0.135 | 0.902 | 11.963 | 0.104 | 0.834 | 15.460 | 1.298 | 4.8 |
| Ex.9 | TPC+Ag190ppm | 21,000 | 35 | 120 | 134 | 0.135 | 0.902 | 11.963 | 0.104 | 0.834 | 15.460 | 1.298 | 7.9 |
| Ex.10 | TPC+Ag190ppm | 21,000 | 35 | 139 | 135 | 0.131 | 1.357 | 11.998 | 0.110 | 1.104 | 14.857 | 1.191 | 0 |
| Ex.11 | TPC+Ag190ppm | 21,000 | 50 | 119 | 122 | 0.149 | 1.488 | 12.258 | 0.121 | 1.258 | 16.337 | 1.231 | 1.1 |
| Ex.12 | TPC+Ag100ppm | 21,000 | 35 | 125 | 129 | 0.132 | 1.246 | 12.007 | 0.105 | 1.003 | 15.843 | 1.257 | 0.8 |
| Ex.13 | TPC+Ag300ppm | 21,000 | 35 | 122 | 127 | 0.128 | 1.212 | 12.282 | 0.099 | 0.987 | 15.745 | 1.293 | 0.8 |
| Ex.14 | OFC | 23,000 | 35 | 135 | 139 | 0.158 | 1.178 | 13.528 | 0.121 | 0.952 | 16.228 | 1.306 | 1.0 |
| Ex.15 | OFC+Ag100ppm | 23,000 | 35 | 120 | 125 | 0.141 | 1.382 | 12.141 | 0.114 | 0.995 | 16.854 | 1.237 | 0.9 |
| Ex.16 | OFC+Ag190ppm | 23,000 | 35 | 118 | 123 | 0.138 | 1.354 | 12.817 | 0.111 | 0.992 | 16.541 | 1.243 | 0.9 |
| Ex.17 | OFC+Sn50ppm | 23,000 | 35 | 136 | 134 | 0.163 | 1.182 | 12.950 | 0.124 | 0.979 | 16.300 | 1.315 | 1.1 |
| Ex.18 | OFC+Sn300ppm | 23,000 | 35 | 133 | 138 | 0.159 | 1.155 | 13.241 | 0.122 | 1.004 | 16.864 | 1.303 | 1.1 |
| Ex.19 | OFC+Sn470ppm | 23,000 | 35 | 140 | 148 | 0.165 | 1.181 | 13.212 | 0.125 | 0.949 | 15.802 | 1.320 | 1.0 |
| Ex.20 | OFC+Sn1200ppm | 23,000 | 35 | 143 | 151 | 0.142 | 0.993 | 11.535 | 0.105 | 0.955 | 14.213 | 1.352 | 1.0 |
| Ex.21 | OFC+Ag10ppm | 23,000 | 35 | 123 | 128 | 0.147 | 1.380 | 12.342 | 0.112 | 0.990 | 16.314 | 1.313 | 1.0 |
| Comp. Ex.1 | TPC | 32,000 | 35 | 96 | 102 | 0.237 | 1.804 | 10.147 | 0.170 | 1.420 | 12.400 | 1.394 | 0 |

| | Composition (wtppm) | Oil film equivalent at final pass of final cold rolling | Thickness ($\mu$m) | Properties after final rolling | | | | | | | | | Ra$_1$ /Ra$_2$ | Amount of electropolishing (one side)($\mu$m) |
|---|---|---|---|---|---|---|---|---|---|---|---|---|---|---|
| | | | | 60 degree gloss | | Surface roughness($\mu$m) RD | | | Surface roughness($\mu$m) TD | | | | | |
| | | | | G60$_{RD}$ | G60$_{TD}$ | Ra$_1$ | R$_t$ | R$_{sm}$ | Ra$_2$ | R$_t$ | R$_{sm}$ | | | |
| Comp. Ex.2 | TPC | 32,000 | 35 | 96 | 102 | 0.237 | 1.804 | 10.147 | 0.170 | 1.420 | 12.400 | 1.394 | 0.2 |
| Comp. Ex.3 | TPC+Ag190ppm | 32,000 | 35 | 92 | 97 | 0.253 | 1.902 | 9.963 | 0.181 | 1.151 | 11.324 | 1.398 | 0 |
| Comp. Ex.4 | TPC+Ag190ppm | 32,000 | 35 | 92 | 97 | 0.253 | 1.902 | 9.963 | 0.181 | 1.151 | 11.324 | 1.398 | 0.4 |
| Comp. Ex.5 | TPC+Ag100ppm | 18,000 | 35 | 380 | 198 | 0.056 | 0.368 | 11.385 | 0.088 | 0.951 | 10.877 | 0.636 | 0 |
| Comp. Ex.6 | OFC | 30,000 | 18 | 108 | 113 | 0.236 | 1.723 | 10.886 | 0.172 | 1.404 | 12.222 | 1.372 | 0 |
| Comp. Ex.7 | OFC | 30,000 | 18 | 108 | 113 | 0.236 | 1.723 | 10.886 | 0.172 | 1.404 | 12.222 | 1.372 | 0.2 |
| Comp. Ex.8 | OFC+Sn1200ppm | 30,000 | 35 | 117 | 122 | 0.248 | 1.702 | 10.410 | 0.178 | 1.396 | 12.868 | 1.393 | 0 |
| Comp. Ex.9 | OFC+Sn1200ppm | 30,000 | 35 | 117 | 122 | 0.248 | 1.702 | 10.410 | 0.178 | 1.396 | 12.868 | 1.393 | 0.2 |
| Comp. Ex.10 | OFC+Sn1200ppm | 23,000 | 35 | 140 | 148 | 0.142 | 1.181 | 13.212 | 0.105 | 0.949 | 15.802 | 1.352 | 0 |
| Comp. Ex.11 | OFC+Sn1200ppm | 23,000 | 35 | 140 | 148 | 0.142 | 1.181 | 13.212 | 0.105 | 0.949 | 15.802 | 1.352 | 0.2 |
| Comp. Ex.12 | OFC+Sn1200ppm | 23,000 | 35 | 140 | 148 | 0.142 | 1.181 | 13.212 | 0.105 | 0.949 | 15.802 | 1.352 | 0.2 |
| Comp. Ex.13 | TPC | 32,000 | 18 | 102 | 110 | 0.225 | 1.774 | 10.008 | 0.167 | 1.389 | 12.115 | 1.347 | 0.3 |

[Table 2]

| | Properties after electropolishing | | | | | | | | Ra$_1$/Ra$_2$ | Properties after heating at 1000°C | | | | | | | | Ra$_1$/Ra$_2$ | Yield of graphene |
| | 60 degree gloss | | Surface roughness ($\mu$m) RD | | | Surface roughness ($\mu$m) TD | | | | 60 degree gloss | | Surface roughness ($\mu$m) RD | | | Surface roughness ($\mu$m) TD | | | | |
| | G60$_{RD}$ | G60$_{TD}$ | Ra$_1$ | Rt | Rsm | Ra$_2$ | Rt | Rsm | | G60$_{RD}$ | G60$_{TD}$ | Ra$_1$ | Rt | Rsm | Ra$_2$ | Rt | Rsm | | |
|---|---|---|---|---|---|---|---|---|---|---|---|---|---|---|---|---|---|---|---|
| Ex.1 | 266 | 270 | 0.117 | 0.987 | 16.258 | 0.093 | 0.938 | 22.446 | 1.258 | 275 | 281 | 0.098 | 0.852 | 19.343 | 0.086 | 0.951 | 22.714 | 1.140 | Excellent |
| Ex.2 | 273 | 274 | 0.108 | 0.889 | 12.036 | 0.091 | 0.999 | 21.374 | 1.187 | 270 | 277 | 0.106 | 0.843 | 20.242 | 0.124 | 1.205 | 23.920 | 0.855 | Excellent |
| Ex.3 | 339 | 347 | 0.038 | 0.540 | 19.454 | 0.040 | 0.705 | 21.952 | 0.950 | 248 | 253 | 0.135 | 1.820 | 26.510 | 0.127 | 1.246 | 31.006 | 1.063 | Not bad |
| Ex.4 | 321 | 325 | 0.062 | 0.585 | 20.290 | 0.063 | 0.735 | 22.997 | 0.984 | 257 | 262 | 0.134 | 1.066 | 26.890 | 0.138 | 0.957 | 25.932 | 0.971 | Not bad |
| Ex.5 | 265 | 277 | 0.125 | 0.996 | 17.874 | 0.099 | 0.954 | 23.432 | 1.263 | 264 | 268 | 0.113 | 0.975 | 19.222 | 0.104 | 0.933 | 23.226 | 1.087 | Excellent |
| Ex.6 | 279 | 284 | 0.110 | 0.952 | 18.446 | 0.089 | 0.903 | 24.665 | 1.236 | 271 | 275 | 0.101 | 0.880 | 18.567 | 0.086 | 0.864 | 19.338 | 1.174 | Excellent |
| Ex.7 | 318 | 321 | 0.075 | 0.490 | 16.140 | 0.059 | 0.629 | 24.407 | 1.271 | 311 | 318 | 0.071 | 0.502 | 17.353 | 0.060 | 0.412 | 19.747 | 1.183 | Excellent |
| Ex.8 | 332 | 337 | 0.041 | 0.355 | 22.472 | 0.032 | 0.252 | 22.863 | 1.281 | 328 | 335 | 0.062 | 0.557 | 22.677 | 0.058 | 0.489 | 17.085 | 1.069 | Good |
| Ex.9 | 338 | 342 | 0.043 | 0.554 | 19.121 | 0.047 | 0.562 | 25.394 | 0.915 | 345 | 349 | 0.045 | 0.554 | 19.121 | 0.050 | 0.657 | 21.932 | 0.900 | Good |
| Ex.10 | 139 | 135 | 0.131 | 1.357 | 11.998 | 0.110 | 1.104 | 14.857 | 1.191 | 184 | 181 | 0.123 | 1.156 | 18.775 | 0.105 | 0.981 | 20.884 | 1.171 | Excellent |
| Ex.11 | 287 | 291 | 0.104 | 0.873 | 19.468 | 0.088 | 0.831 | 25.970 | 1.182 | 308 | 313 | 0.093 | 0.879 | 18.747 | 0.085 | 0.862 | 21.200 | 1.094 | Excellent |
| Ex.12 | 277 | 281 | 0.113 | 0.910 | 15.988 | 0.094 | 0.898 | 22.535 | 1.202 | 305 | 311 | 0.090 | 0.933 | 18.554 | 0.082 | 0.910 | 21.121 | 1.098 | Excellent |
| Ex.13 | 275 | 277 | 0.111 | 0.902 | 16.227 | 0.098 | 0.885 | 23.412 | 1.133 | 306 | 312 | 0.088 | 0.988 | 18.314 | 0.084 | 0.935 | 22.475 | 1.048 | Excellent |
| Ex.14 | 269 | 273 | 0.123 | 0.951 | 16.286 | 0.109 | 0.946 | 23.800 | 1.128 | 298 | 309 | 0.088 | 0.642 | 18.522 | 0.086 | 0.603 | 22.804 | 1.023 | Excellent |
| Ex.15 | 272 | 277 | 0.108 | 0.877 | 19.521 | 0.090 | 0.847 | 24.112 | 1.200 | 301 | 315 | 0.088 | 0.955 | 17.258 | 0.081 | 0.852 | 21.147 | 1.086 | Excellent |
| Ex.16 | 274 | 280 | 0.105 | 0.875 | 19.224 | 0.088 | 0.822 | 25.553 | 1.193 | 309 | 318 | 0.082 | 0.941 | 17.963 | 0.077 | 0.846 | 21.369 | 1.065 | Excellent |
| Ex.17 | 273 | 282 | 0.128 | 0.974 | 16.143 | 0.113 | 0.960 | 23.434 | 1.133 | 300 | 304 | 0.090 | 0.925 | 18.645 | 0.083 | 0.844 | 23.010 | 1.084 | Excellent |
| Ex.18 | 281 | 285 | 0.115 | 1.032 | 16.444 | 0.110 | 0.937 | 23.667 | 1.045 | 288 | 295 | 0.097 | 1.108 | 19.487 | 0.092 | 0.976 | 23.579 | 1.054 | Excellent |
| Ex.19 | 285 | 288 | 0.109 | 1.003 | 16.879 | 0.096 | 0.922 | 23.161 | 1.135 | 302 | 308 | 0.091 | 0.852 | 18.455 | 0.088 | 0.833 | 23.002 | 1.034 | Excellent |
| Ex.20 | 288 | 292 | 0.103 | 0.954 | 17.141 | 0.091 | 0.902 | 23.868 | 1.132 | 305 | 310 | 0.087 | 0.924 | 19.446 | 0.082 | 0.877 | 23.468 | 1.061 | Excellent |
| Ex.21 | 270 | 275 | 0.114 | 0.896 | 18.424 | 0.098 | 0.958 | 23.103 | 1.163 | 303 | 311 | 0.089 | 0.851 | 18.322 | 0.083 | 0.784 | 22.653 | 1.072 | Excellent |
| Comp. Ex.1 | 96 | 102 | 0.236 | 1.804 | 10.147 | 0.172 | 1.420 | 12.400 | 1.372 | 100 | 109 | 0.198 | 0.985 | 19.548 | 0.162 | 1.122 | 20.414 | 1.222 | Bad |

| | Properties after electropolishing | | | | | | | | Ra₁ /Ra₂ | Properties after heating at 1000°C | | | | | | | | Ra₁ /Ra₂ | Yield of graphene |
|---|---|---|---|---|---|---|---|---|---|---|---|---|---|---|---|---|---|---|---|
| | 60 degree gloss | | Surface roughness (μm) RD | | | Surface roughness (μm) TD | | | $Ra_1/Ra_2$ | 60 degree gloss | | Surface roughness (μm) RD | | | Surface roughness (μm) TD | | | $Ra_1/Ra_2$ | Yield of graphene |
| | $G60_{RD}$ | $G60_{TD}$ | $Ra_1$ | Rt | Rsm | $Ra_2$ | Rt | Rsm | | $G60_{RD}$ | $G60_{TD}$ | $Ra_1$ | Rt | Rsm | $Ra_2$ | Rt | Rsm | | |
| Comp. Ex.2 | 100 | 106 | 0.230 | 1.444 | 14.253 | 0.169 | 1.273 | 16.135 | 1.361 | 108 | 115 | 0.189 | 1.588 | 20.147 | 0.155 | 1.050 | 22.877 | 1.219 | Bad |
| Comp. Ex.3 | 92 | 97 | 0.252 | 1.902 | 9.963 | 0.181 | 1.151 | 11.324 | 1.392 | 98 | 107 | 0.218 | 1.018 | 20.692 | 0.168 | 0.993 | 23.456 | 1.298 | Bad |
| Comp. Ex.4 | 98 | 100 | 0.237 | 1.371 | 15.641 | 0.168 | 1.278 | 18.567 | 1.411 | 102 | 104 | 0.207 | 1.600 | 21.345 | 0.160 | 1.437 | 23.850 | 1.294 | Bad |
| Comp. Ex.5 | 380 | 198 | 0.056 | 0.368 | 11.385 | 0.088 | 0.951 | 10.877 | 0.636 | 385 | 204 | 0.054 | 0.681 | 17.225 | 0.072 | 0.841 | 20.117 | 0.750 | Bad |
| Comp. Ex.6 | 108 | 113 | 0.236 | 1.723 | 10.886 | 0.172 | 1.404 | 12.222 | 1.372 | 121 | 130 | 0.192 | 1.647 | 23.147 | 0.158 | 1.495 | 21.013 | 1.215 | Bad |
| Comp. Ex.7 | 114 | 117 | 0.223 | 1.688 | 11.487 | 0.161 | 1.405 | 13.336 | 1.385 | 126 | 138 | 0.190 | 1.641 | 24.001 | 0.152 | 1.506 | 23.002 | 1.250 | Bad |
| Comp. Ex.8 | 117 | 122 | 0.249 | 1.702 | 10.410 | 0.178 | 1.396 | 12.868 | 1.399 | 128 | 135 | 0.218 | 1.633 | 23.878 | 0.169 | 1.500 | 23.510 | 1.290 | Bad |
| Comp. Ex.9 | 121 | 127 | 0.238 | 1.621 | 12.004 | 0.175 | 1.477 | 14.550 | 1.360 | 133 | 139 | 0.198 | 1.602 | 23.474 | 0.159 | 1.313 | 24.011 | 1.245 | Bad |
| Comp. Ex.10 | 140 | 148 | 0.142 | 1.181 | 13.212 | 0.105 | 0.949 | 15.802 | 1.352 | 155 | 159 | 0.128 | 1.602 | 23.474 | 0.099 | 1.313 | 24.011 | 1.293 | Bad |
| Comp. Ex.11 | 144 | 152 | 0.138 | 1.158 | 14.468 | 0.103 | 0.949 | 15.802 | 1.340 | 133 | 139 | 0.118 | 1.602 | 23.474 | 0.093 | 1.313 | 24.011 | 1.269 | Bad |
| Comp. Ex.12 | 144 | 152 | 0.138 | 1.158 | 14.468 | 0.103 | 0.949 | 15.802 | 1.340 | 133 | 139 | 0.118 | 1.602 | 23.474 | 0.093 | 1.313 | 24.011 | 1.269 | Bad |
| Comp. Ex.13 | 108 | 113 | 0.208 | 1.687 | 14.285 | 0.149 | 1.367 | 17.412 | 1.396 | 113 | 118 | 0.187 | 1.610 | 19.885 | 0.144 | 1.331 | 23.187 | 1.299 | Bad |

As apparent from Tables 1 and 2, in each of Examples 1 to 9, 11 to 20 where the copper foil surface was electropolished to a depth of 0.5 $\mu$m or more and in Example 10 where the roll was used by decreasing a difference between roughness in a circumferential direction and roughness in a width direction in a final pass of a final cold rolling, $0.7 <= (Ra_1/Ra_2) <= 1.3$ was satisfied. Thus, the production yield of the graphene was high.

On the other hand, in each of Comparative Examples 1, 3, 5, 7, 9 and 10 where the copper foil surface was not electropolished and in each of Comparative Examples 2, 4, 6, 8, 11 to 13 where the amount of the electropolishing was less than 0.5 $\mu$m, $0.7 <= (Ra_1/Ra_2) <= 1.3$ was not satisfied. Thus, the production yield of the graphene was low. In Comparative Example 13, the copper foil surface was electropolished under the electropolishing conditions similar to those described in the above-described Non-Patent Literature 2 (a phosphoric acid 65% + sulfuric acid 10% + water 25% solution at a voltage of about 10 $V/cm^2$) for 30 minutes.

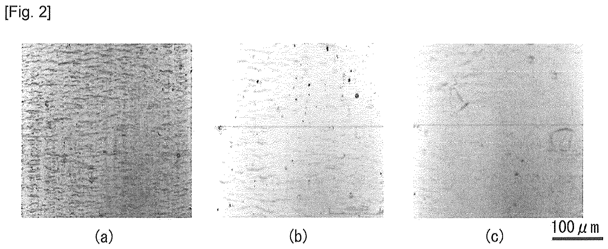

Fig. 2 (a) is a confocal micrograph of the surface of the sample in Example 6 after the sample was finally cold rolled, Fig. 2 (b) is a confocal micrograph of the surface of the sample in Example 6 after electropolishing, and Fig. 2 (c) is a confocal micrograph of the surface of the sample in Example 6 heated at 1000°C for 1 hour after electropolishing. It shows that electropolishing enables the roughness and the oil pit on the copper foil surface to be smoothed and the value of the $(Ra_1/Ra_2)$ to be decreased, thereby decreasing anisotropy.

[Explanation of Reference Numerals]

10   copper foil for producing graphene
20   graphene
30   transfer sheet

**Claims**

1.  A copper foil for producing graphene consisting of tough pitch copper in accordance with JIS-H3100, or consisting of oxygen free copper in accordance with JIS-H3100, or containing from 0.001% by mass to 0.15% by mass of one or more of elements selected from the group consisting of Sn and Ag to the tough pitch copper or the oxygen free copper,

    having a thickness of 18 to 50 $\mu$m, **characterized by** having 60 degree gloss in a rolling direction and 60 degree gloss in a direction transverse to rolling direction of each 200% or more to less than 500%, and having a ratio $(Ra_1/Ra_2)$ between an arithmetic mean roughness $Ra_1$ in the rolling direction and an arithmetic mean roughness $Ra_2$ in the direction transverse to rolling direction of $0.7 <= (Ra_1/Ra_2) <= 1.3$.

2.  The copper foil for producing graphene according to Claim 1, wherein the ratio $(Ra_1/Ra_2)$ is $0.8 <= (Ra_1/Ra_2) <= 1.2$ after heating at 1000 °C for 1 hour in an atmosphere containing 20% by volume or more of hydrogen and balance argon.

3.  A method of producing the copper foil for producing graphene according to Claim 1 or 2, electropolishing a surface of a copper foil substrate to 0.5 $\mu$m or more in a depth direction.

4.  A method of producing the copper foil for producing graphene according to Claim 1 or 2, rolling with a roll having a ratio $(Ra_{1roll}/Ra_{2roll})$ between an arithmetic mean roughness in a circumferential direction $Ra_{1roll}$ and an arithmetic mean roughness in a width direction $Ra_{2roll}$ is $0.8 <= (Ra_{1roll}/Ra_{2roll}) <= 1.2$ at a final pass of a final cold rolling.

5.  A method of producing graphene using the copper foil for producing graphene according to Claim 1 or 2, comprising the steps of:

    providing a hydrogen and carbon-containing gas while placing the heated copper foil in a chamber to form graphene on a surface of the copper foil for producing graphene;
    laminating a transfer sheet on the surface of the graphene, and etching and removing the copper foil for producing graphene while transferring the graphene to the transfer sheet.

**Patentansprüche**

1. Kupferfolie zur Herstellung von Graphen bestehend aus zähgepoltem Kupfer gemäß JIS-H3100, oder bestehend aus sauerstofffreiem Kupfer gemäß JIS-H3100, oder enthaltend 0,001 Massen-% bis 0,15 Massen-% eines oder mehrerer Elements / Elemente ausgewählt aus der Gruppe bestehend aus Sn und Ag bezogen auf das zähgepolte Kupfer oder das sauerstofffreie Kupfer,
aufweisend eine Dicke von 18 bis 50 $\mu$m,
**dadurch gekennzeichnet, dass** sie einen Glanz bei 60° in einer Rollrichtung und einen Glanz bei 60° in einer Richtung quer zur Rollrichtung von jeweils 200% oder mehr bis weniger als 500% aufweist,
und dass sie ein Verhältnis $(Ra_1/Ra_2)$ zwischen einer arithmetischen mittleren Rauheit $Ra_1$ in der Rollrichtung und einer arithmetischen mittleren Rauheit $Ra_2$ in der Richtung quer zur Rollrichtung von $0,7 \le (Ra_1/Ra_2) \le 1,3$ aufweist.

2. Kupferfolie zur Herstellung von Graphen gemäß Anspruch 1, wobei das Verhältnis $(Ra_1/Ra_2)$ nach dem Erhitzen bei 1000°C eine Stunde lang in einer Atmosphäre, welche 20 Volumen-% oder mehr Wasserstoff und Rest Argon aufweist, $0,8 \le (Ra_1/Ra_2) \le 1,2$ beträgt.

3. Verfahren zur Herstellung der Kupferfolie zur Herstellung von Graphen gemäß Anspruch 1 oder 2, wobei eine Oberfläche eines Kupferfolien-Substrats auf 0,5 $\mu$m oder mehr in einer Tiefenrichtung elektropoliert wird.

4. Verfahren zur Herstellung der Kupferfolie zur Herstellung von Graphen gemäß Anspruch 1 oder 2,
welche beim Rollen mit einer Rolle ein Verhältnis $(Ra_{1roll}/Ra_{2roll})$ von einer arithmetischen mittleren Rauheit in einer Umfangsrichtung $Ra_{1roll}$ und einer arithmetischen mittleren Rauheit in einer Weiten-Richtung $Ra_{2roll}$ $0,8 \le (Ra_1/Ra_2) \le 1,2$ in einem letzten Durchgang eines letzten kalten Rollens aufweist.

5. Verfahren zur Herstellung von Graphen unter Verwendung der Kupferfolie zur Herstellung von Graphen gemäß Anspruch 1 oder 2, umfassend die folgenden Schritte:

   Bereitstellen eines Gases, das Wasserstoff und Kohlenstoff enthält, während die erhitzte Kupferfolie in einer Kammer positioniert wird, um Graphen auf einer Oberfläche der Kupferfolie zur Herstellung von Graphen zu bilden;
   Beschichten eines Transferbogens auf die Oberfläche des Graphens, und Ätzen und Entfernen der Kupferfolie zur Herstellung von Graphen, während das Graphen auf den Transferbogen transferiert wird.

**Revendications**

1. Feuille de cuivre pour la production de graphène se composant d'un cuivre désoxydé conformément à la norme japonaise JIS-H3100 ou se composant de cuivre exempt d'oxygène conformément à la norme japonaise JIS-H3100, ou contenant de 0,001 % en poids à 0,15 % en poids d'un ou de plusieurs éléments choisis dans le groupe constitué de Sn et d'Ag par rapport au cuivre désoxydé ou au cuivre exempt d'oxygène,
ayant une épaisseur de 18 à 50 $\mu$m,
**caractérisée en ce qu'**elle possède une brillance à 60 degrés dans un sens du laminage et une brillance à 60 degrés dans un sens transversal au sens du laminage de, chacune, 200 % ou plus à moins de 500 %,
et un rapport $(Ra_1/Ra_2)$ entre une rugosité moyenne arithmétique $Ra_1$ dans le sens du laminage et une rugosité moyenne arithmétique $Ra_2$ dans le sens transversal du sens du laminage de $0,7 <= (Ra_1/Ra_2) <= 1,3$.

2. Feuille de cuivre pour la production de graphène selon la revendication 1, dans laquelle le rapport $(Ra_1/Ra_2)$ est de $0,8 <= (Ra_1/Ra_2) <= 1,2$ après chauffage à 1 000 °C pendant 1 heure dans une atmosphère contenant 20 % en volume ou plus d'hydrogène et le reste d'argon.

3. Procédé de production de la feuille de cuivre pour la production de graphène selon la revendication 1 ou 2, comprenant l'électro-polissage d'une surface d'un substrat de la feuille de cuivre jusqu'à 0,5 $\mu$m ou plus dans un sens de la profondeur.

4. Procédé de production de la feuille de cuivre pour la production de graphène selon la revendication 1 ou 2, comprenant le laminage avec un rouleau ayant un rapport $(Ra_{1rouleau}/Ra_{2rouleau})$ entre une rugosité moyenne arithmétique dans un sens circonférentiel $Ra_{1rouleau}$ et une rugosité moyenne arithmétique dans un sens de la largeur $Ra_{2rouleau}$ de $0,8 <= (Ra_{1rouleau}/Ra_{2rouleau}) <= 1,2$ au niveau d'un passage final d'un laminage à froid final.

**5.** Procédé de production de graphène en utilisant la feuille de cuivre pour la production de graphène selon la revendication 1 ou 2, comprenant les étapes consistant à :

fournir un hydrogène et un gaz contenant du carbone tout en plaçant la feuille de cuivre chauffée dans une chambre afin de former du graphène sur une surface de la feuille de cuivre pour produire du graphène ; stratifier une feuille de transfert sur la surface du graphène, et graver et éliminer la feuille de cuivre pour produire du graphène tout en transférant le graphène sur la feuille de transfert.

[Fig. 1]

[Fig. 2]

(a)　　　　　　　　(b)　　　　　　　　(c)　　　100 μm

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 2009143799 A

**Non-patent literature cited in the description**

• *SCIENCE,* 2009, vol. 324, 1312-1314